# EUROPEAN PATENT APPLICATION

(11) **EP 4 621 085 A1**
(43) Date of publication of application: **24.09.2025**
(21) Application number: 24813828.1
(22) Date of filing: 18.03.2024
(51) Int. Cl.: C22C 1/04, B22F 10/28, C22C 23/04, B33Y 10/00, B33Y 70/00, B22F 10/60, C23C 14/48, C23C 14/14, B33Y 40/20

(54) **MEDICAL MAGNESIUM ALLOY AND PREPARATION METHOD THEREFOR**

(30) Priority: 31.05.2023 CN 202310631085
(71) Applicant: Beijing AK Medical Co., Ltd., Beijing, 102200 (CN)
(72) Inventor: WANG, Caimei, Beijing 102200 (CN); MA, Xiaolin, Beijing 102200 (CN); TIAN, Yun, Beijing 102200 (CN); CUI, Wen, Beijing 102200 (CN)
(74) Representative: Novagraaf Technologies
(86) International application number: PCT/CN2024/082278
(87) International publication number: WO 2024/244622

(57) **Abstract**

Provided is a medical magnesium alloy and a preparation method therefor. The preparation method includes: magnesium alloy powder is printed into a formed magnesium alloy sample by means of a laser fusion additive manufacturing technology; the outer surface of the formed magnesium alloy sample is physically polished; and in an oxygen-enriched environment, heating treatment is performed on the physically-polished formed magnesium alloy sample, to obtain the medical magnesium alloy, herein the magnesium alloy powder includes, in percentage by weight, 0.15-0.4 wt% of zinc, 0.01-0.05 wt% of manganese, 0.5-2.2 wt% of neodymium, 3.7-4.3 wt% of yttrium, and the balance of magnesium. By means of the preparation method, the medical magnesium alloy obtained in the present disclosure is not prone to experiencing quick degradation in a physiological environment, has good corrosion resistance, has better development prospects in the biomedicine field, and also has excellent high-strength performance

## Description

This application claims priority to Chinese patent application 2023106310852, filed on May 31, 2023, the disclosure of which is hereby incorporated by reference in its entirety.

### Technical Field

The present disclosure relates to the technical field of magnesium alloys, in particular to a medical magnesium alloy and a preparation method therefor.

### Background

The density of magnesium metal is only 1.8 g/cm³, and it is the lightest metal structural material. Magnesium alloys also have high specific strength, specific stiffness, shock absorption, recyclability, and good thermal and electrical conductivity and the like, it is beneficial for industrial processing and forming, and it is known as "21st century green engineering metal". Therefore, as one of excellent performance engineering materials, the magnesium metal is widely used in military weapons, transportation, electronic communication, medical health and other fields.

Since the magnesium alloys have excellent biocompatibility and their comprehensive mechanical properties such as an elasticity modulus are close to those of human bones, the magnesium alloys have attracted more and more attention in fields such as biomedicine. However, the magnesium alloys have high chemical activity, are easily degraded rapidly in physiological environments, and have relatively poor mechanical properties, which seriously hinder its development and application in the biomedical field. Therefore, effectively controlling the degradation rate of the magnesium alloys and improving the mechanical properties of the magnesium alloys play an important role in expanding medical applications of the magnesium alloys.

### Summary

A main purpose of the present disclosure is to provide a medical magnesium alloy and a preparation method therefor, as to solve problems of magnesium alloys in existing technologies that the degradation rate in physiological environments is relatively rapid, mechanical properties are relatively poor, and the application requirements in the biomedical field may not be satisfied.

In order to achieve the above purpose, according to one aspect of the present disclosure, a preparation method for a medical magnesium alloy is provided, it includes: magnesium alloy powder is printed into a formed magnesium alloy sample by means of a laser fusion additive manufacturing technology; the outer surface of the formed magnesium alloy sample is physically polished; and in an oxygen-enriched environment, heating treatment is performed on the physically-polished formed magnesium alloy sample, to obtain the medical magnesium alloy; herein the magnesium alloy powder includes, in percentage by weight, 0.15-0.4 wt% of zinc, 0.01-0.05 wt% of manganese, 0.5-2.2 wt% of neodymium, 3.7-4.3 wt% of yttrium, and the balance of magnesium.

Further, the magnesium alloy powder further includes 1.5-3.5 wt% of scandium; preferably, the particle size of the magnesium alloy powder is 20-80 µm, the D50 particle size is 45-50 µm, and the degree of sphericity is greater than 98%; further preferably, calculated in percentage by weight, the magnesium alloy powder is composed of 0.15 wt% of zinc, 0.01 wt% of manganese, 0.5 wt% of neodymium, 3.7 wt% of yttrium, 1.5 wt% of scandium, and the balance of magnesium; alternatively, the magnesium alloy powder is composed of 0.20 wt% of zinc, 0.02 wt% of manganese, 1 wt% of neodymium, 3.8 wt% of yttrium, 2.0 wt% of scandium, and the balance of magnesium; alternatively, the magnesium alloy powder is composed of 0.25 wt% of zinc, 0.03 wt% of manganese, 1.5 wt% of neodymium, 3.9 wt% of yttrium, 2.5 wt% of scandium, and the balance of magnesium; alternatively, the magnesium alloy powder is composed of 0.30 wt% of zinc, 0.04 wt% of manganese, 2.0 wt% of neodymium, 4.0 wt% of yttrium, 3.0 wt% of scandium, and the balance of magnesium; alternatively, the magnesium alloy powder is composed of 0.40 wt% of zinc, 0.05 wt% of manganese, 2.2 wt% of neodymium, 4.3 wt% of yttrium, 3.5 wt% of scandium, and the balance of magnesium; alternatively, the magnesium alloy powder is composed of 0.20 wt% of zinc, 0.03 wt% of manganese, 2.0 wt% of neodymium, 3.7 wt% of yttrium, 3.0 wt% of scandium, and the balance of magnesium.

Further, the heating treatment includes: the physically-polished formed magnesium alloy sample is heated first in the oxygen-enriched environment at a temperature of 520-530 °C for 6-10 h; then the heated formed magnesium alloy sample is water cooled in the oxygen-enriched environment at a temperature of 20-25 °C and a cooling rate of 100-200 °C/s, to obtain the medical magnesium alloy; preferably, in the oxygen-enriched environment, the oxygen volume content is ≥90%, further preferably ≥99%.

Further, the oxygen pressure in the heating process is ≤1 bar, preferably 0.3-0.6 bar; preferably, the oxygen flow rate in the heating process is 0.5-1 L/min.

Further, the treatment time for the water cooling is 3-5 s; preferably, in the water cooling process, the volume of water used is 30-50 times greater than the volume of the heated formed magnesium alloy sample; preferably, the oxygen flow rate in the water cooling process is 0.5-1 L/min.

Further, the physical polishing is performed by using a mode of sandblasting treatment; preferably, compressed air with a pressure of 2-6 bar is used as a carrier gas to carry hydroxyapatite powder, and the sandblasting treatment is performed; further preferably, the particle size of the hydroxyapatite powder is <100 µm, preferably 60-80 µm.

Further, the printing is performed in a laser powder bed melting device; preferably, in the printing process, the laser power is 60-120 W, the scanning speed is 500-1200 mm/s, the powder coating thickness of each printing layer is 20-50 µm, and an argon gas is used as a protective gas.

Further, before the physical polishing treatment, the preparation method further includes a step of using the compressed air to remove surface free powder particles of the formed magnesium alloy sample.

Further, after the water cooling, the preparation method further includes: a water-cooled material is taken out from water, the water-cooled material is blow-dried first with the compressed air, then the water-cooled material is placed in anhydrous ethanol and ultrasonic-cleaned for 10-15 min, and finally the water-cooled material is dried, to obtain the medical magnesium alloy.

Further, after the physical polishing and before the heating treatment, the preparation method further includes: yttrium ions are deposited on the outer surface of the formed magnesium alloy sample by using a mode of ion implantation; preferably, the implantation dose of the yttrium ions is 5×10¹⁶-5×10¹⁷ ions/cm².

In order to achieve the above purpose, according to one aspect of the present disclosure, a medical magnesium alloy prepared by the abovementioned preparation method for the medical magnesium alloy is provided.

Based on the above preparation method, the medical magnesium alloy obtained in the present disclosure is not prone to experiencing quick degradation in the physiological environment, has good corrosion resistance, has better development prospects in the biomedicine field, and also has excellent mechanical properties.

### Brief Description of the Drawings

Drawings of the description for constituting a part of the present disclosure are used to provide further understanding of the present disclosure. Schematic examples of the present disclosure and descriptions thereof are used to explain the present disclosure and do not constitute improper limitations on the present disclosure. In the drawings:
FIG. 1 shows a measurement diagram of a film thickness of a formed magnesium alloy sample obtained in Example 1.
FIG. 2 shows an ultimate tensile strength test diagram of formed magnesium alloy samples obtained in Example 1 and Contrast example 1.
FIG. 3 shows a compression strength test diagram of the formed magnesium alloy samples obtained in Example 1 and Contrast example 1.
FIG. 4 shows an elasticity coefficient test diagram of the formed magnesium alloy samples obtained in Example 1 and Contrast example 1.
FIG. 5 shows a surface element analysis diagram of the formed magnesium alloy sample obtained in Example 1.
FIG. 6 shows a degradation process diagram of a medical magnesium alloy sample obtained in Example 1 in simulated body fluid (Hanks).
FIG. 7 shows a scanning electron microscopy test diagram of a medical magnesium alloy sample obtained in Contrast example 1.
FIG. 8 shows a scanning electron microscopy test diagram of a medical magnesium alloy sample obtained in Example 1.
FIG. 9 shows a hydrogen evolution test diagram of medical magnesium alloy samples obtained in Example 1, Example 2, and Contrast example 1 in the simulated body fluid (Hanks).

### Detailed Description of the Embodiments

It should be noted that examples in the present disclosure and features in the examples may be combined with each other without conflicting. The present disclosure is described in detail below with reference to the drawings and in combination with the examples.

As described in the background section of the present disclosure, there is a problem in existing technologies that magnesium alloys are relatively rapid in degradation rate and relatively poor in mechanical properties. In order to solve this problem, the present disclosure provides a preparation method for a medical magnesium alloy, and the method includes: magnesium alloy powder is printed into a formed magnesium alloy sample by means of a laser fusion additive manufacturing technology; the outer surface of the formed magnesium alloy sample is physically polished; and in an oxygen-enriched environment, heating treatment is performed on the physically-polished formed magnesium alloy sample, to obtain the medical magnesium alloy; herein the magnesium alloy powder includes, in percentage by weight, 0.15-0.4 wt% of zinc, 0.01-0.05 wt% of manganese, 0.5-2.2 wt% of neodymium, 3.7-4.3 wt% of yttrium, and the balance of magnesium.

Firstly, the magnesium alloy powder includes 0.15-0.4 wt% of zinc, 0.01-0.05 wt% of manganese, 0.5-2.2 wt% of neodymium, 3.7-4.3 wt% of yttrium, and the balance of magnesium. Firstly, the melting point of zinc (419.58 °C) is relatively low, similar to the crystal structure of magnesium (hcp), and has a similar atomic radius to magnesium. It may form continuous solid solution with magnesium and has a higher solid solubility in magnesium (about 6.2%). On the one hand, zinc may combine with neodymium and yttrium, to form a high-strength precipitation strengthened magnesium alloy, thereby the strength of the product is enhanced. On the other hand, zinc may also refine grains, reduce stress corrosion sensitivity, and thereby enhance the corrosion resistance of the product. Secondly, compared to other metal elements (such as iron), adding manganese to the magnesium alloy may not only make the product have excellent strength and corrosion resistance, but also have the better weldability, which has positive significance for improving the melt quality in an additive manufacturing micro-casting technology and has the better industrial application prospects. Thirdly, the addition of neodymium and yttrium may not only improve the strength of the magnesium alloy, but also enhance the corrosion resistance of the magnesium alloy. Specifically, after the heating treatment, neodymium and yttrium may form a dense passivation layer (oxide film) on the surface of the magnesium alloy product, and the formation of the passivation layer may significantly reduce the degradation rate of the magnesium alloy. At the same time, there may also be a large amount of an yttrium-zinc phase and a magnesium-yttrium phase generated in the product, so that the probability of generating MgZn and MgZn₂ phases and the probability of their growth are reduced. In this way, a precipitated phase of an yttrium-containing alloy may become more, more dispersed, and finer, thereby the alloy structure **of the product** is refined, and the tensile strength and corrosion resistance of the product are improved.

Secondly, it is found by the inventor that the flowability of the magnesium alloy powder containing 0.15-0.4 wt% of zinc, 0.01-0.05 wt% of manganese, 0.5-2.2 wt% of neodymium, 3.7-4.3 wt% of yttrium, and the balance of magnesium is not very well. Therefore, the magnesium alloy powder with specific components may be further printed to obtain the high-performance formed magnesium alloy sample in combination with the micro-casting laser fusion additive manufacturing technology, and the application prospects are better.

Furthermore, the surface smoothness of the formed magnesium alloy sample printed from the magnesium alloy powder by using the laser fusion additive manufacturing technology is insufficient. Such a sample is difficult to form a dense and continuous passivation layer (oxide film) on the surface during the subsequent heating treatment. Therefore, in the present disclosure, the outer surface of the formed magnesium alloy sample is physically polished first before the heating treatment. It should be further noted here that in this field, chemical modes (such as acid treatment) are often chosen for the surface smoothness treatment of the magnesium alloy sample. However, these chemical modes fail to effectively improve the surface smoothness of the sample, resulting in the inability to form the dense and continuous oxide film during the subsequent heating treatment process. At the same time, when reagents (such as acids) are used for treatment, it is inevitable that a chemical reaction may occur with active metals (such as Mg) or surface yttrium in the magnesium alloy sample, the formation and content of the oxide film are directly affected, thereby it is caused that the passivation quality of the magnesium alloy is poor, the corrosion resistance is insufficient, and the product application performance is decreased. Moreover, in actual production, a large-scale acid washing operation may have operational safety and environmental pollution problems, and the acid washing time is not easy to control. The physical polishing mode used in the present disclosure may not only make the outer surface of the formed magnesium alloy sample smoother, but also facilitate the formation of the dense and continuous passivation layer (oxide film) in the subsequent heating treatment. The product may have excellent strength performance and corrosion resistance at the same time, and the operation is simpler and faster, the safety is better.

In particular, it is also found by the applicant that during high-temperature heating treatment in a conventional air environment, magnesium is prone to react with certain substances (such as CO₂) to generate impurities (such as MgCO₃), this may affect the passivation effect of magnesium, thereby the density and continuity of the passivation layer of the product are reduced, thus the degradation rate of the magnesium alloy is still unable to effectively meet the requirements of biomedical applications. The present disclosure performs the heating treatment on the physically-polished formed magnesium alloy sample in the oxygen-enriched environment, the above problems are avoided, the degradation rate of the magnesium alloy may be significantly slowed down, and the strength of the magnesium alloy is improved.

In conclusion, based on the above preparation method, the medical magnesium alloy obtained in the present disclosure is not easily degraded rapidly in the physiological environment, has excellent corrosion resistance, has better development prospects in the biomedical field, and also has excellent high-strength performance.

In order to further slowdown the degradation rate of the product, preferably the magnesium alloy powder further includes 1.5-3.5 wt% of scandium. The addition of scandium may improve the strength and plasticity of the magnesium alloy. The ultimate solid solubility of scandium in magnesium is higher than that of other rare earth elements, and the strength and plasticity of the magnesium alloy may be improved by age hardening and weakening texture effects.

In some preferred embodiments, calculated in percentage by weight, the magnesium alloy powder is composed of 0.15 wt% of zinc, 0.01 wt% of manganese, 0.5 wt% of neodymium, 3.7 wt% of yttrium, 1.5 wt% of scandium, and the balance of magnesium; alternatively, the magnesium alloy powder is composed of 0.20 wt% of zinc, 0.02 wt% of manganese, 1 wt% of neodymium, 3.8 wt% of yttrium, 2.0 wt% of scandium, and the balance of magnesium; alternatively, the magnesium alloy powder is composed of 0.25 wt% of zinc, 0.03 wt% of manganese, 1.5 wt% of neodymium, 3.9 wt% of yttrium, 2.5 wt% of scandium, and the balance of magnesium; alternatively, the magnesium alloy powder is composed of 0.30 wt% of zinc, 0.04 wt% of manganese, 2.0 wt% of neodymium, 4.0 wt% of yttrium, 3.0 wt% of scandium, and the balance of magnesium; alternatively, the magnesium alloy powder is composed of 0.40 wt% of zinc, 0.05 wt% of manganese, 2.2 wt% of neodymium, 4.3 wt% of yttrium, 3.5 wt% of scandium, and the balance of magnesium; alternatively, the magnesium alloy powder is composed of 0.20 wt% of zinc, 0.03 wt% of manganese, 2.0 wt% of neodymium, 3.7 wt% of yttrium, 3.0 wt% of scandium, and the balance of magnesium.

In a preferred embodiment, the particle size of the magnesium alloy powder is 20-80 µm, the D50 particle size is 45-50 µm, and the degree of sphericity is greater than 98%. This is based on the consideration that: the particle size of the magnesium alloy powder is less than 20 µm and the D50 particle size is less than 45 µm, which on the one hand it increases safety risks and may easily lead to explosions, requiring high safety requirements for device operations and posing significant safety hazards; and on the other hand, it may accelerate the degradation rate of the product. If the particle size of the magnesium alloy powder is higher than 80 µm and the D50 particle size is higher than 50 µm, it may lead to poor melting quality of the magnesium alloy, easy internal defects, low density, poor product surface quality, especially accelerated degradation rate and other problems. Therefore, based on the above starting point, the particle size of the magnesium alloy powder in the present disclosure is 20-80 µm, the D50 particle size is 45-50 µm, and the degree of sphericity is greater than 98%. In this way, the safety is better and the product has better performance in all aspects.

In order to further improve the strength of the product and slow down the degradation rate of the product, the heating treatment includes: the physically-polished formed magnesium alloy sample is heated first in the oxygen-enriched environment at a temperature of 520-530 °C for 6-10 h; then the heated formed magnesium alloy sample is water-cooled in the oxygen-enriched environment at a temperature of 20-25 °C and a cooling rate of 100-200 °C/s (such as 100 °C/s, 150 °C/s, or 200 °C/s), to obtain the medical magnesium alloy. In order to further improve the corrosion resistance of the product, in a preferred embodiment, in the oxygen-enriched environment, the oxygen volume content is ≥90%, for example, it may be 90%, 92%, 94%, 96%, 98% or 100%; further preferably it is ≥99%,

In order to make the stability of the heating treatment process better and make the uniformity of the product performance better, in a preferred embodiment, the oxygen pressure in the heating process is ≤1 bar, preferably 0.3-0.6 bar. The oxygen flow rate in the heating process is 0.5-1 L/min. The treatment time for the water cooling is 3-5 s. In the water cooling process, the volume of water used is 30-50 times (for example, it may be 30 times, 35 times, 40 times, 45 times, or 50 times) greater than the volume of the heated formed magnesium alloy sample. The oxygen flow rate in the water cooling process is 0.5-1 L/min. Based on this, the density and continuity of the magnesium passivation layer are better, which may enable the degradation rate and strength of the magnesium alloy to better meet the application requirements in the biomedical field.

In order to further improve the efficiency of sandblasting treatment, the physical polishing is performed by using a mode of sandblasting treatment. In a preferred embodiment, compressed air with a pressure of 2-6 bar is used as a carrier gas to carry hydroxyapatite powder, and the sandblasting treatment is performed. The hydroxyapatite powder is hard in texture, moderate in particle size, good in biocompatibility, and harmless to the human body. The compressed air with the pressure of 2-6 bar is used as the carrier gas to carry the hydroxyapatite powder for the sandblasting treatment, making it more beneficial for the formation of the dense and continuous passivation layer (oxide film) in the subsequent heating treatment, and the product may have excellent strength and corrosion resistance at the same time, the operation is simpler and faster, and the safety is better. Preferably, the particle size of the hydroxyapatite powder is < 100 µm, further preferably 60-80 µm, such as 60 µm, 70 µm, or 80 µm. In a preferred embodiment, the compressed air with the pressure of 2-6 bar is used as the carrier gas to carry the hydroxyapatite powder for the sandblasting treatment, until the surface is smooth (bright silver appears).

In a preferred embodiment, the printing is performed in a laser powder bed melting device. In the printing process, the laser power is 60-120 W, such as 60 W, 80 W, 100 W, or 120 W; the scanning speed is 500-1200 mm/s, such as 500 mm/s, 600 mm/s, 700 mm/s, 800 mm/s, 900 mm/s, 1000 mm/s, 1100 mm/s, or 1200 mm/s; the powder coating thickness of each printing layer is controlled at 20-50 µm, such as 20 µm, 30 µm, 40 µm, or 50 µm; and in the printing process, an argon gas is used as a protective gas, and the oxygen volume content in the system is not higher than 0.001%.

In order to further improve the subsequent physical polishing efficiency, before the physical polishing, the preparation method further includes a step of using the compressed air to remove surface free powder particles of the formed magnesium alloy sample.

In order to further remove surface floating residues of the product, preferably after the water cooling, the preparation method further includes: a water-cooled material is taken out from water, the water-cooled material is blow-dried first with the compressed air, then the water-cooled material is placed in anhydrous ethanol and ultrasonic-cleaned for 10-15 min, and finally the water-cooled material is placed in a drying oven for drying, to obtain the medical magnesium alloy.

In order to further improve the corrosion resistance of the product, in a preferred embodiment, after the physical polishing and before the heating treatment, the preparation method further includes: yttrium ions are deposited on the outer surface of the formed magnesium alloy sample by using a mode of ion implantation. The mode of ion implantation is to accelerate ions to be injected into the product in vacuum and at a low temperature, and the ions with high kinetic energy may directly enter the product. Preferably, the implantation dose of the yttrium ions is 5×10¹⁶-5×10¹⁷ ions/cm².

The present disclosure further provides a medical magnesium alloy prepared by the abovementioned preparation method for the medical magnesium alloy. Based on the reasons mentioned earlier, the medical magnesium alloy in the present disclosure not only meets the requirements of physiological degradation rate, but also has excellent strength performance.

The present disclosure is further described in detail below in combination with specific examples, and these examples should not be construed as limiting the scope of protection claimed by the present disclosure.

### Example 1

Magnesium alloy powder used in this example was the magnesium alloy powder in a customized formula produced by Tangshan Weihao Magnesium Powder Co., Ltd., its components and particle size met the requirements for raw material powder in the present disclosure. The magnesium alloy powder included 0.2 wt% of zinc, 0.03 wt% of manganese, 2.0 wt% of neodymium, 3.7 wt% of yttrium, 3.0 wt% of scandium, and the balance of magnesium. The D50 particle size of the magnesium alloy powder was 47 µm and the degree of sphericity was 99%.

An S-210 laser powder bed melting device produced by Xi'an Bright Additive Technology Co., Ltd. was used to print the above magnesium alloy powder into a formed magnesium alloy sample.

A porous model was manufactured, and the model was placed in slicing software special for a printing device for slicing. A generated file after the slicing was imported into the 3D printing device for printing. In the printing process, an argon gas was used as a protective gas, the laser power was 100 W, the scanning speed was 1000 mm/s, the preheating temperature was 200 °C, and the powder coating thickness of each layer was controlled at 40 µm. After the printing was completed, a sample piece was removed from a substrate and avoided contacting with water, grease and the like in the removing process.

Compressed air with a pressure of 3 bar was used to remove surface free powder particles of the formed magnesium alloy sample.

The compressed air with the pressure of 3 bar was used as a carrier gas to carry hydroxyapatite powder (the particle size was 80 µm), sandblasting treatment was performed on the outer surface of the formed magnesium alloy sample, until the magnesium alloy surface appeared bright silver. Then, it was taken out and placed in anhydrous ethanol for 10 min of ultrasonic-cleaning. After the ultrasonic-cleaning, the magnesium alloy sample was taken out and placed in an air drying oven for drying (the temperature was 50 °C).

The cleaned and dried magnesium alloy sample was placed into a tube furnace (it had a heating tube and a tail portion of the heating tube was connected to a sealed water tank. The sealed water tank was connected with a temperature sensor that might measure the temperature inside the tank, and the sealed water tank contained deionized water) for heating treatment. Before the heating was started, an oxygen-enriched gas (the oxygen purity was greater than 99.99%) was first fed into the heating tube of the tube furnace for 10 min, to clean the heating tube. The heating tube was heated after being sealed, it was heated at a heating rate of 10 °C/min until it reached 525 °C, and the temperature was kept for 8 h. The heating process was performed in an oxygen-enriched environment, the oxygen pressure was 0.5 bar, and the oxygen flow rate was 0.75 L/min.

After the heating was ended, the magnesium alloy sample was not taken out, and the quartz tube was rotated, so that the sample fell into the sealed water tank connected to the tail portion for cooling. The sealed water tank contained the deionized water, and its volume was 40 times greater than the volume of the heated formed magnesium alloy sample. The temperature of the deionized water was 20 °C, and the oxygen flow rate in the water cooling process was 0.75 L/min.

After 5 s, the magnesium alloy sample was taken out from the water and blow-dried with the compressed air.

### Example 2

The only difference from Example 1 was that: after the sandblasting treatment and before the heating treatment, the preparation method further included the following steps: an ion implantation machine and a dual Penning-type multi-charge heavy ion source were used, an yttrium oxide was used as a sputtering material for ion implantation, yttrium ions were deposited on the outer surface of the formed magnesium alloy sample; and the implantation dose of the yttrium ions was 1×10¹⁷ ions/cm², and the implantation depth reached 1 µm.

### Contrast example 1

The only difference from Example 1 was that: the magnesium alloy powder included 0.03 wt% of manganese, 2.0 wt% of neodymium, 3.7 wt% of yttrium, 3.0 wt% of scandium, and the balance of magnesium.

### Contrast example 2

The only difference from Example 1 was that: the heating treatment was performed under an atmospheric environment.

### Performance characterization:

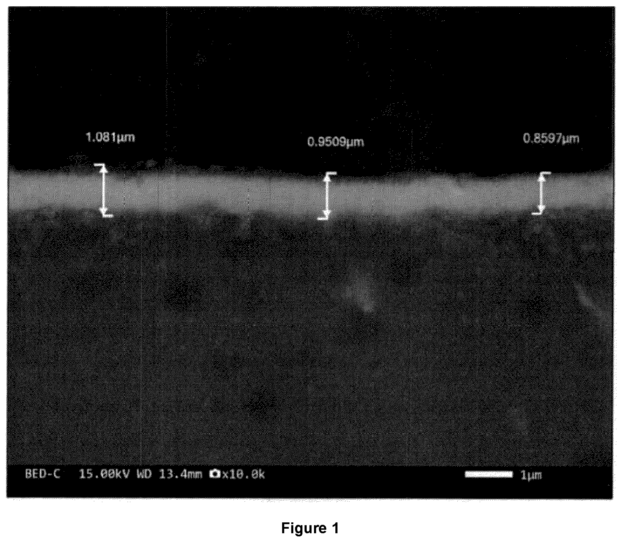

FIG. 1 shows a measurement diagram of a film thickness of a formed magnesium alloy sample obtained in Example 1. It may be seen from FIG. 1 that the thickness of the oxide film is relatively stable and uniform, about 1 µm.

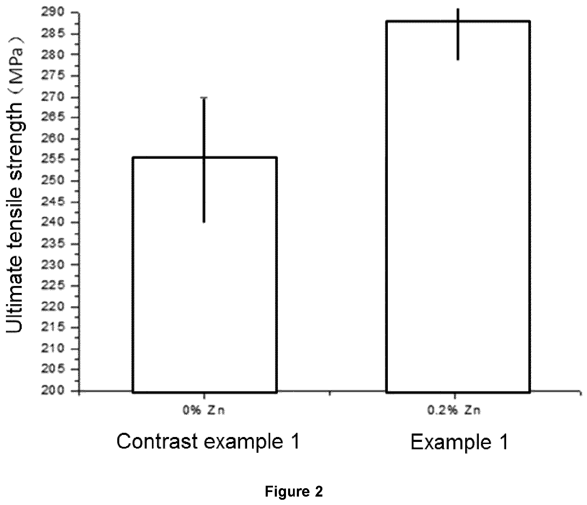

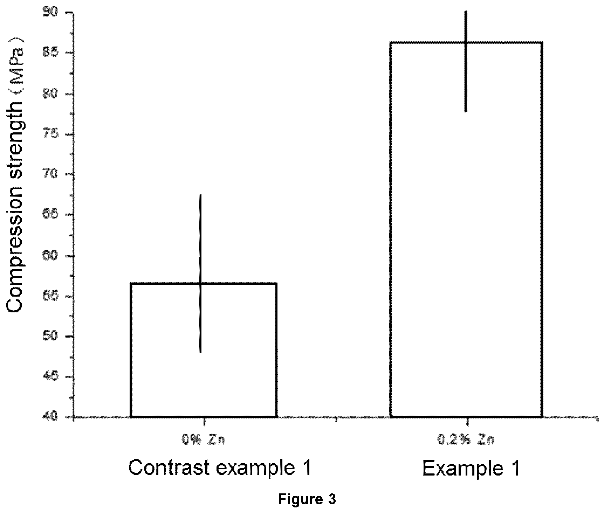

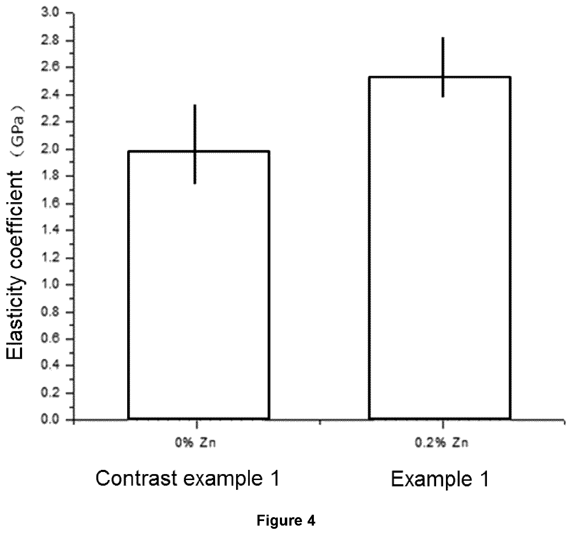

FIGs. 2, 3, and 4 show mechanical property test diagrams of formed magnesium alloy samples obtained in Example 1 and Contrast example 1. Herein, FIG. 2 shows an ultimate tensile strength test diagram of the formed magnesium alloy samples obtained in Example 1 and Contrast example 1; FIG. 3 shows a compression strength test diagram of the formed magnesium alloy samples obtained in Example 1 and Contrast example 1; and FIG. 4 shows an elasticity coefficient test diagram of the formed magnesium alloy samples obtained in Example 1 and Contrast example 1. From FIGs. 2, 3, and 4, it may be seen that the addition of zinc and the limitation of zinc content within the usage range of 0.15-0.4 wt% have a significant impact on the mechanical properties of the product, herein the effects of the compression strength and the ultimate tensile strength are more apparent.

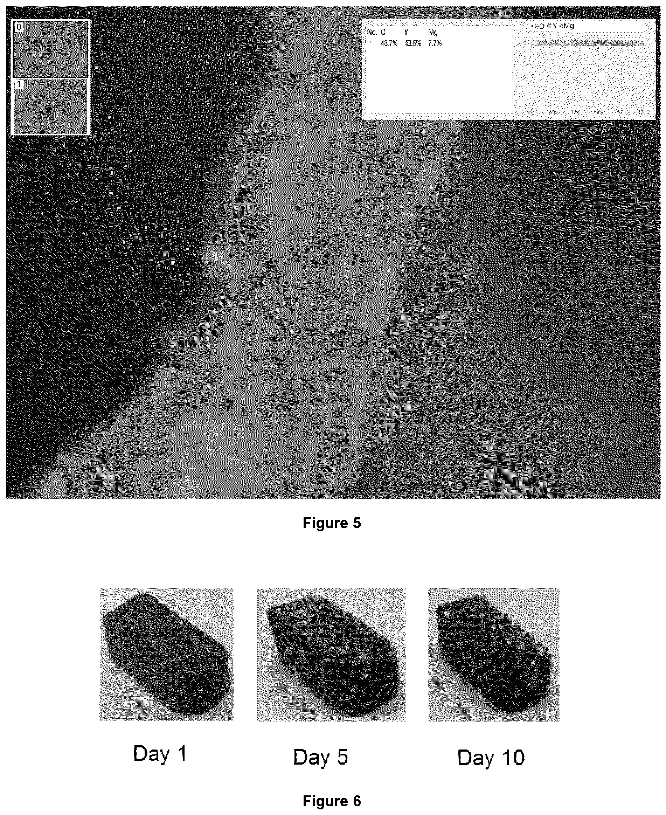

FIG. 5 shows a surface element analysis diagram of the formed magnesium alloy sample obtained in Example 1. From FIG. 5, it may be seen that the surface yttrium and oxygen content are significantly increased, and the effect of surface oxidation is achieved.

FIG. 6 shows a degradation process diagram of a medical magnesium alloy sample (sample size: 10×10 mm, height: 20 mm, porosity: 60%, average pore size: 0.45 µm, and surface area: about 3275 mm²) obtained in Example 1 in simulated body fluid (Hanks). From FIG. 6, it may be seen that the modified magnesium alloy is gradually corroded in the simulated body fluid, the weight is reduced by only 50% after 10 days, and the degradation rate of the magnesium alloy in the physiological environment is greatly slowed down.

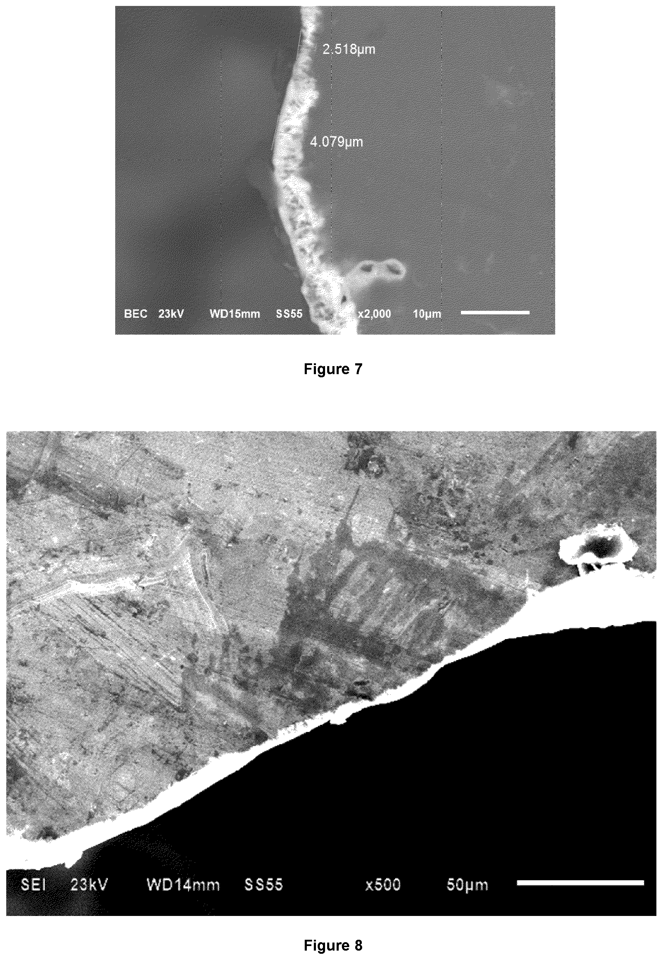

FIG. 7 shows a scanning electron microscopy test diagram of a medical magnesium alloy sample obtained in Contrast example 1. FIG. 8 shows a scanning electron microscopy test diagram of a medical magnesium alloy sample obtained in Example 1. From FIGs. 7 and 8, it may be seen that the film generated by the heating treatment in the atmospheric environment is loose and not dense. The film generated by the heating treatment in the oxygen-enriched environment is dense and uniform in thickness.

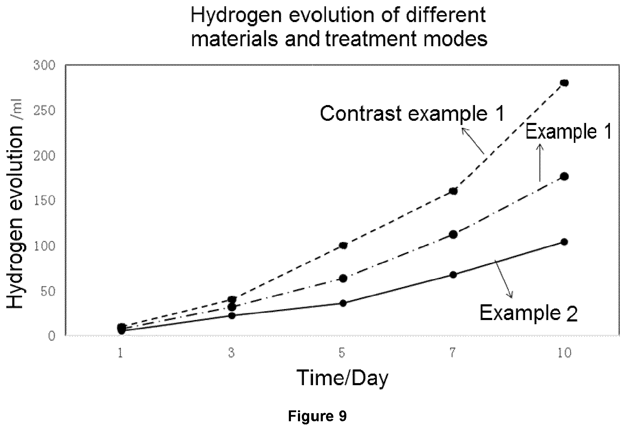

FIG. 9 shows a hydrogen evolution test diagram of medical magnesium alloy samples obtained in Example 1, Example 2, and Contrast example 1 in the simulated body fluid (Hanks). From FIG. 9, it may be seen that the corrosion resistance of the medical magnesium alloy sample in Example 2 is better than that of the medical magnesium alloy sample in Example 1, and the corrosion resistance of the medical magnesium alloy sample in Example 1 is better than that of the medical magnesium alloy sample in Contrast example 1.

The above are only preferred examples of the present disclosure and are not intended to limit the present disclosure. For those skilled in the art, the present disclosure may have various modifications and variations. Any modifications, equivalent replacements, improvements and the like made within the spirit and principles of the present disclosure shall be contained within the scope of protection of the present disclosure.

## Claims

1. A preparation method for a medical magnesium alloy, comprising:
printing magnesium alloy powder into a formed magnesium alloy sample by means of a laser fusion additive manufacturing technology;
physically polishing the outer surface of the formed magnesium alloy sample; and
in an oxygen-enriched environment, performing heating treatment on the physically-polished formed magnesium alloy sample, to obtain a medical magnesium alloy;
wherein the magnesium alloy powder comprises, in percentage by weight, 0.15-0.4 wt% of zinc, 0.01-0.05 wt% of manganese, 0.5-2.2 wt% of neodymium, 3.7-4.3 wt% of yttrium, and the balance of magnesium.

2. The preparation method for the medical magnesium alloy according to claim 1, wherein the magnesium alloy powder further comprises 1.5-3.5 wt% of scandium;
the particle size of the magnesium alloy powder is 20-80 µm, the D50 particle size is 45-50 µm, and the degree of sphericity is greater than 98%.

3. The preparation method for the medical magnesium alloy according to claim 2, wherein the heating treatment comprises: first heating the physically-polished formed magnesium alloy sample in the oxygen-enriched environment at a temperature of 520-530 °C for 6-10 h; then water cooling the heated formed magnesium alloy sample in the oxygen-enriched environment at a temperature of 20-25 °C and a cooling rate of 100-200 °C/s, to obtain the medical magnesium alloy;
in the oxygen-enriched environment, the oxygen volume content is ≥90%.

4. The preparation method for the medical magnesium alloy according to claim 3, wherein the oxygen pressure in the heating process is ≤1 bar; and
the oxygen flow rate in the heating process is 0.5-1 L/min.

5. The preparation method for the medical magnesium alloy according to claim 3, wherein the water cooling treatment time is 3-5 s;
in the water cooling process, the volume of water used is 30-50 times greater than the volume of the heated formed magnesium alloy sample;
the oxygen flow rate in the water cooling process is 0.5-1 L/min;
after the water cooling, the preparation method further comprises: taking out a water-cooled material from water, first blow-drying the water-cooled material with compressed air, then placing the water-cooled material in anhydrous ethanol and ultrasonic-cleaning for 10-15 min, and finally drying the water-cooled material, to obtain the medical magnesium alloy.

6. The preparation method for the medical magnesium alloy according to any one of claims 1 to 5, wherein the physical polishing is performed by using a mode of sandblasting treatment;
the compressed air with a pressure of 2-6 bar is used as a carrier gas to carry hydroxyapatite powder, and the sandblasting treatment is performed;
the particle size of the hydroxyapatite powder is <100 µm.

7. The preparation method for the medical magnesium alloy according to claim 1, wherein the printing is performed in a laser powder bed melting device;
in the printing process, the laser power is 60-120 W, the scanning speed is 500-1200 mm/s, the powder coating thickness of each printing layer is 20-50 µm, and an argon gas is used as a protective gas.

8. The preparation method for the medical magnesium alloy according to claim 1, wherein before the physical polishing treatment, the preparation method further comprises a step of using the compressed air to remove surface free powder particles of the formed magnesium alloy sample.

9. The preparation method for the medical magnesium alloy according to claim 1, wherein after the physical polishing and before the heating treatment, the preparation method further comprises: depositing yttrium ions on the outer surface of the formed magnesium alloy sample by using a mode of ion implantation;
the implantation dose of the yttrium ions is 5×10¹⁶-5×10¹⁷ ions/cm².

10. A medical magnesium alloy prepared by the preparation method for the medical magnesium alloy according to any one of claims 1 to 9.
